(19) Europäisches Patentamt
European Patent Office
Office européen des brevets

(11) **EP 4 707 922 A2**

(12) **EUROPEAN PATENT APPLICATION**

(43) Date of publication:
**11.03.2026 Bulletin 2026/11**

(21) Application number: **25199255.8**

(22) Date of filing: **01.09.2025**

(51) International Patent Classification (IPC):
*G03F 7/00* (2006.01)

(52) Cooperative Patent Classification (CPC):
G03F 7/0002

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.09.2024 JP 2024154234**

(71) Applicant: **CANON KABUSHIKI KAISHA**
**Ohta-ku**
**Tokyo 146-8501 (JP)**

(72) Inventor: **KAGAWA, Masayuki**
**Tokyo, 146-8501 (JP)**

(74) Representative: **TBK**
**Bavariaring 4-6**
**80336 München (DE)**

(54) **CORRECTION METHOD, MOLD MANUFACTURING METHOD, IMPRINT METHOD, ARTICLE MANUFACTURING METHOD, AND INFORMATION PROCESSING APPARATUS**

(57) The present disclosure provides a correction method of correcting, by an information processing apparatus, design data of a pattern of a mold to be used in an imprint process of forming a pattern in an imprint material on a substrate, comprising: obtaining an actual volume of a concave pattern element formed in a test mold; determining a correction value for correcting a difference between the actual volume and a design volume of the pattern element by a dimension of the pattern element in a plane direction parallel to a surface of the test mold; and correcting the design data based on the correction value.

**FIG. 3**

START

PREPARE TEST MOLD — S11

MEASURE AREA AND DIMENSION OF EACH OF TYPES OF PATTERN ELEMENTS — S12

OBTAIN ACTUAL VOLUME OF EACH OF TYPES OF PATTERN ELEMENTS — S13

DETERMINE DATA BIAS AMOUNT OF EACH OF TYPES OF PATTERN ELEMENTS — S14

OBTAIN DESIGN DATA — S15

CORRECT DESIGN DATA BASED ON DATA BIAS AMOUNT — S16

END

EP 4 707 922 A2

**Description**

TECHNICAL FIELD

The present disclosure relates to a correction method, a mold manufacturing method, an imprint method, an article manufacturing method, and an information processing apparatus.

BACKGROUND

In recent years, as one of lithography techniques for satisfying a demand for microfabrication of a semiconductor device or the like, an imprint technique has been developed. The imprint technique is a technique of forming a pattern in an imprint material on a substrate by curing the imprint material in a state in which the imprint material on the substrate is in contact with a mold including a concave-convex pattern. In the imprint technique, as described in, for example, Japanese Patent Laid-Open No. 2022-182991, the arrangement pattern (drop pattern) of an imprint material supplied as a plurality of droplets onto a substrate can be generated based on the design data (layout data) of the pattern of a mold. By using such the imprint technique, a fine concave-convex structure on the nanometer order formed by the cured film of an imprint material can be formed on a substrate.

Unlike masks used in other lithography techniques (for example, an exposure apparatus), the mold used in the imprint technique is provided with a pattern formed from a plurality of concave pattern elements arranged three-dimensionally. However, the volume of each pattern element in the mold can be different from the design value (design volume) due to a fabrication process or the like. In this case, it can be difficult to accurately form a pattern in an imprint material on a substrate using the mold.

SUMMARY

The present disclosure provides a technique advantageous in accurately manufacturing a mold used for an imprint technique.

The present disclosure in its first aspect provides a correction method as specified in claim 1. Optional features are specified in claim 2 to 10.

The present disclosure in its second aspect provides a mold manufacturing method as specified in claim 11.

The present disclosure in its third aspect provides an imprint method as specified in claim 12.

The present disclosure in its fourth aspect provides an article manufacturing method as specified in claim 13.

The present disclosure in its fifth aspect provides an information processing apparatus as specified in claim 14.

Features of the present disclosure will become apparent from the following description of embodiments with reference to the attached drawings. The following description of embodiments is described by way of example.

BRIEF DESCRIPTION OF THE DRAWINGS

The accompanying drawings, which are incorporated in and constitute a part of the specification, illustrate embodiments of the present disclosure, and together with the description, serve to explain the principles of the embodiments.

Fig. 1 is a schematic view showing an example of the arrangement of an imprint apparatus;
Fig. 2 is a schematic view showing an example of the configuration of a correction system;
Fig. 3 is a flowchart illustrating a method of correcting design data according to the first embodiment;
Figs. 4A to 4D are schematic views for explaining the definitions of the area and dimension of a pattern element;
Fig. 5 is a flowchart illustrating a method of determining a data bias amount;
Figs. 6A and 6B are schematic views for explaining parameters used when determining the data bias amount;
Fig. 7 is a view showing an example of correction information;
Figs. 8A and 8B are schematic view for explaining an example of correcting the dimension of a pattern element in a plane direction in accordance with the data bias amount in the design data of the mold;
Fig. 9 is a schematic view showing an example of the design data of the mold before correction;
Fig. 10 is a view showing an example of correction information;
Fig. 11 is a flowchart illustrating a method of correcting design data according to the third embodiment;
Figs. 12A and 12B are schematic views each showing the configurations and arrangements of the first pattern element and the second pattern element;
Figs. 13A to 13C are views showing an example of a result of correcting the design data of a mold; and
Figs. 14A to 14F are views for explaining an article manufacturing method.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

In the specification and the accompanying drawings, directions will be indicated on an XYZ coordinate system in which a plane direction parallel to the surface of a mold where a concave-convex pattern is formed is defined as the X and Y directions, unless otherwise specified. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are $\theta X$, $\theta Y$, and $\theta Z$, respectively. Control or driving concerning the X-axis, the Y-axis, and the Z-axis means control or driving concerning a direction parallel to the X-axis, a direction parallel to the Y-axis, and a direction parallel to the Z-axis, respectively. In addition, control or driving concerning the $\theta X$-axis, the $\theta Y$-axis, and the $\theta Z$-axis means control or driving concerning a rotation about an axis parallel to the X-axis, a rotation about an axis parallel to the Y-axis, and a rotation about an axis parallel to the Z-axis, respectively. In addition, a position is information that can be specified based on coordinates on the X-, Y-, and Z-axes, and a posture is information that can be specified by values on the $\theta X$-, $\theta Y$-, and $\theta Z$-axes.

<First Embodiment>

The first embodiment according to the present disclosure will be described. An imprint apparatus is a lithography apparatus that forms a pattern in an imprint material (composition) on a substrate by using a mold, and can be employed in a lithography step for manufacturing a semiconductor device, a magnetic storage medium, or the like. The imprint apparatus performs a process of forming a pattern of a cured material, to which the pattern of a mold is transferred, on a substrate by bringing an uncured imprint material supplied onto the substrate into contact with the mold and applying curing energy to the imprint material. This process is called an imprint process, and performed for each of a plurality of shot regions (imprint regions) on a substrate. In this embodiment, an example will be described in which a photo-curing method of curing an imprint material on a substrate by irradiating the imprint material with light (ultraviolet light) is employed.

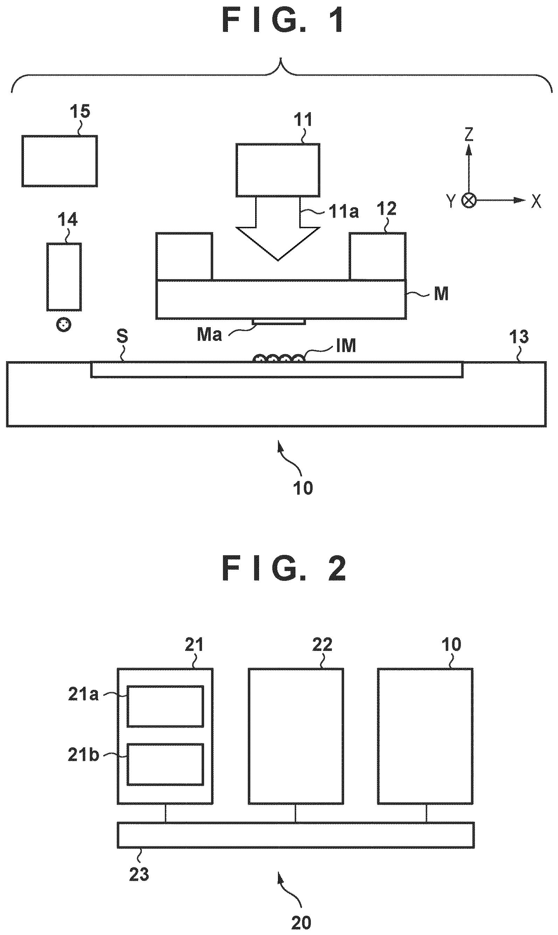

Fig. 1 is a schematic view showing an example of the arrangement of an imprint apparatus 10 in this embodiment. The imprint apparatus 10 in this embodiment can include a light irradiator 11, a mold holder 12, a substrate stage 13, a supplier 14, and a controller 15. The controller 15 is formed from, for example, a computer (information processing apparatus) including a processor such as a Central Processing Unit (CPU) and a storage unit such as a memory, and controls the imprint process by controlling respective units of the imprint apparatus 10.

During the imprint process, the light irradiator 11 (curing unit) irradiates an imprint material IM with light 11a (for example, ultraviolet light) in a state in which the imprint material IM on a substrate S (on a shot region) is in contact with a mold M, thereby curing the imprint material IM. The light irradiator 11 can include, for example, a light source, and an optical device for adjusting the light emitted from the light source to light suitable for the imprint process.

The mold holder 12 is a mechanism that moves the mold M in the Z direction while holding the mold M. More specifically, the mold holder 12 can include a mold chuck that holds the mold M by a vacuum suction force or the like, and a mold driving mechanism that drives the mold M (mold chuck). The mold holder 12 drives the mold M in the Z direction in a step (contact step) of bringing the mold M into contact with the imprint material IM on the substrate S, and a step (mold separation step) of separating the mold M from the cured imprint material IM on the substrate S. The mold holder 12 may be configured to have a position adjustment function for adjusting the position of the mold M not only in the Z direction but also in the X direction, the Y direction, and rotating directions about the respective axes ($\theta X$, $\theta Y$, and $\theta Z$ directions).

The mold M generally has a rectangular outer peripheral shape, and is made of a material that can transmit the light 11a (ultraviolet light), such as silica glass. A partial region of the surface of the mold M which faces the substrate S is provided with a mesa portion Ma formed in a mesa shape having a level difference of, for example, about several tens of $\mu m$. The surface of the mesa portion Ma on the substrate S side is a contact surface to be brought into contact with the imprint material IM on the substrate S, and formed as a pattern surface where a concave-convex pattern, such as a circuit pattern, to be transferred to the imprint material IM on the substrate S is formed three-dimensionally. The mesa portion Ma formed with a concave-convex pattern will sometimes be referred to as the "pattern portion Ma" hereinafter.

The substrate stage 13 is a mechanism that moves the substrate S in the X and Y directions while holding the substrate S. More specifically, the substrate stage 13 includes a substrate chuck that holds the substrate S by a vacuum suction force or the like, and a substrate driving mechanism that drives the substrate S (substrate chuck). In alignment between the mold M (pattern portion Ma) and the substrate S (shot region), the substrate stage 13 drives the substrate S in the X and Y directions. The substrate stage 13 may be formed from a plurality of driving systems such as a coarse driving system and a fine driving system for each of the X direction and the Y direction. The substrate stage 13 may be configured to have a position adjusting function for adjusting the position of the substrate S not only in the X and Y directions but also in the Z direction and the rotating directions about the respective axes (the θX, θY, and θZ directions).

Here, the contact step and the mold separation step in an imprint process may be implemented by driving the mold M in the Z direction by the mold holder 12, but may be implemented by driving the substrate S in the Z direction by the substrate stage 13. Alternatively, the contact step and the mold separation step may be implemented by relatively driving the mold M and the substrate S in the Z direction by both the mold holder 12 and the substrate stage 13.

As the material for the substrate S, for example, glass, ceramics, a metal, a semiconductor, a resin, or the like is used. A member made of a material different from that of the substrate S may be provided on the surface of the substrate S, as needed. The substrate S can be, for example, a silicon wafer, a semiconductor compound wafer, silica glass, or the like.

The supplier 14 supplies the imprint material IM as a plurality of droplets onto the substrate S. The supplier 14 may be understood as a discharge head (dispenser) that discharges the imprint material IM as a plurality of droplets toward the substrate S. For example, while causing the substrate stage 13 to move the substrate S in the X and Y directions below the supplier 14, the supplier 14 is caused to discharge the imprint material IM as a plurality of droplets. With this, the imprint material IM can be supplied (arranged) as a plurality of droplets onto the substrate S (shot region).

As the imprint material IM to be supplied onto the substrate S, a curable composition (to be also referred to as a resin in an uncured state) to be cured by receiving curing energy is used. The curable composition is a composition cured by light irradiation or heating. Among these, a photo-curable composition cured by light irradiation contains at least a polymerizable compound and a photopolymerization initiator, and may further contain a nonpolymerizable compound or a solvent, as needed. The nonpolymerizable compound is at least one material selected from the group consisting of a sensitizer, a hydrogen donor, an internal mold release agent, a surfactant, an antioxidant, and a polymer component. The viscosity (the viscosity at 25°C) of the viscous material is, for example, from 1 mPa·s (inclusive) to 100 mPa·s (inclusive).

The imprint apparatus 10 configured as described above sequentially executes the imprint process on each of the plurality of shot regions of the substrate S. In the imprint process, the supplier 14 is first used to supply the imprint material IM as a plurality of droplets onto the substrate S (more specifically, the target shot region of the imprint process) (supply step). Then, after the substrate S is positioned below the mold M by the substrate stage 13, the mold holder 12 drives the mold M in the -Z direction to bring the pattern portion Ma of the mold M into contact with the imprint material IM on the substrate S (contact step). After the mold M and the substrate S are aligned, the light irradiator 11 emits the light 11a to the imprint material IM to cure the imprint material IM (curing step). After the imprint material IM is cured, the mold M is separated from the imprint material IM on the substrate S (mold separation step). Thus, the concave-convex pattern formed of a cured product of the imprint material IM can be formed on the substrate S.

As described above, the mold M to be used in the imprint apparatus 10 can be provided with a concave-convex pattern formed from a plurality of concave pattern elements arranged three-dimensionally. The concave-convex pattern of the mold M is fabricated based on design data such as CAD data. However, due to the fabrication process such as developing or etching, the volume (to be sometimes referred to as the actual volume hereinafter) of each pattern element actually formed in the mold M may be different from the design volume. In this case, it can be difficult to accurately form a pattern in the imprint material IM on the substrate S by the imprint process using the mold M. Generating the design data in the first place so as to reduce the error between the actual volume and the design volume of each pattern element is not advisable because it takes a considerable time. Therefore, in this embodiment, a method of correcting the design data of the pattern of the mold M so as to reduce the error between the actual volume and the design volume of each pattern element is proposed.

Fig. 2 shows an example of the configuration of a correction system 20 for correcting design data. The correction system 20 can include an information processing apparatus 21 and a measurement apparatus 22. Transmission/reception of information and data between the information processing apparatus 21 and the measurement apparatus 22 is performed via a network 23. The above-described imprint apparatus 10 may be provided in the correction system 20. In this case, the imprint apparatus 10 can also be connected to the network 23.

The information processing apparatus 21 is formed from, for example, a computer including a processor 21a such as a Central Processing Unit, CPU, and a storage unit 21b such as a memory. A correction program for correcting design data is stored in the storage unit 21b. The processor 21a can correct design data by reading out and executing the correction program stored in the storage unit 21b. Note that the information processing apparatus 21 may be formed by, for example, a PLD (a short for Programmable Logic Device) such as an FPGA (a short for Field Programmable Gate Array), an ASIC (a short for Application Specific Integrated Circuit), a general-purpose computer with programs installed therein, or a combination of some or all of these.

The measurement apparatus 22 (measurement unit) measures the area and dimension (size) of each of a plurality of types of pattern elements formed in a test mold (to be described later). More specifically, for each of the plurality of types of pattern elements, the measurement apparatus 22 measures the area and dimension of the opening region formed by the pattern element in the surface of the test mold, the area and dimension of the bottom surface of the pattern element, and the depth of the pattern element. With this, the information processing apparatus 21 (processor 21a) can obtain (calculate) the actual volume of each type of pattern element based on the measurement result of the measurement apparatus 22 obtained by the network 23. Here, examples of the measurement apparatus 22 are measurement devices such as an electron microscope (Top View SEM), an atomic force microscope (AFM), and a cross-sectional SEM.

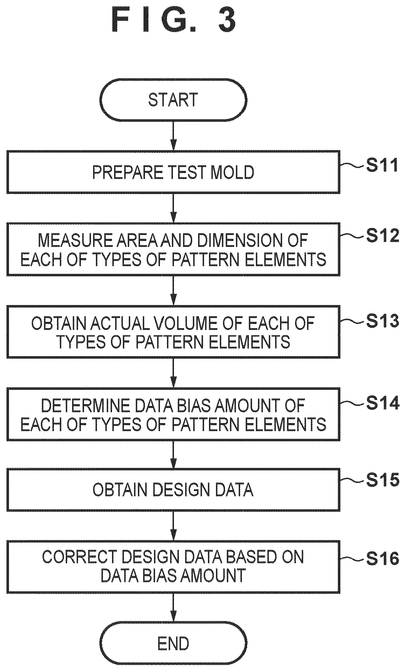

Fig. 3 is a flowchart illustrating a of correcting design data in this embodiment. In the flowchart of Fig. 3, step S12 can be performed by the measurement apparatus 22, and steps S13 to S16 can be performed by the information processing apparatus 21 (processor 21a).

In step S11, a test mold is prepared. A test mold is a condition setting mold for obtaining in advance process errors that can occur in the fabrication process of the mold M to be used in the imprint apparatus 10. Step S11 can include a step of generating test mold design data (to be sometimes referred to as test design data hereinafter), and a step of fabricating (manufacturing) a test mold based on the test design data.

The test mold in this embodiment includes a plurality of types of pattern elements that can constitute the pattern of the mold M to be actually used in the imprint apparatus 10, and may further include other pattern elements. Each of the plurality of types of pattern elements is formed in a concave shape in the test mold by being recessed from the surface of the test mold, and has a tapered shape in the depth direction due to the fabrication process. Each of the plurality of types of pattern elements may be understood as an element that extracts (simulates) a part of the pattern of the mold M, or may be a collection of a plurality of partial elements (for example, a plurality of geometric figures) separate from each other. The plurality of types of pattern elements are different from each other in the configuration condition. The configuration condition can include at least one of the dimension, the depth, the circumferential length (outer circumferential length), the pitch of the plurality of partial elements, and the occupation density per unit area (the density of the partial element). Here, the test design data may be understood as layout data indicating the layout of the plurality of types of pattern elements in the test mold, and can be generated as two-dimensional data or three-dimensional data. The test design data may be generated by the information processing apparatus 21.

In step S12, the measurement apparatus 22 is used to measure the area and dimension of each of the plurality of types of pattern elements formed in the test mold. More specifically, for each of the plurality of types of pattern elements, the measurement apparatus 22 measures the area and dimension of the opening region formed by the pattern element in the surface of the test mold, the area and dimension of the bottom surface of the pattern element, and the depth of the pattern element.

In step S13, the information processing apparatus 21 obtains (calculates) the actual volume of each of the plurality of types of pattern elements. As described above, the actual volume is defined as the actual volume (capacity) of each type of pattern element formed in the test mold. The information processing apparatus 21 can obtain the measurement result of the measurement apparatus 22 in step S12 from the measurement apparatus 22 via the network 23, and calculate the actual volume of each type of pattern element based on the measurement result.

In step S14, for each of the plurality of types of pattern elements, the information processing apparatus 21 determines a correction value for correcting the difference (to be sometimes referred to as the volume error hereinafter) between the actual volume and design volume of the pattern element. The correction value is a value for correcting the volume error by the dimension of the pattern element in the plane direction (X and Y directions) parallel to the surface of the test mold, more specifically, a value defining the amount or ratio of changing the dimension of the pattern element in the plane direction so as to reduce the volume error. The correction value may be understood as a value for compensating the volume error by the amount or ratio of increasing the overall dimension of the pattern element in the plane direction while assuming that the taper angle, which can be generated due to the fabrication process, does not change. By determining the correction value for each of the plurality of types of pattern elements, correction information (for example, a table) indicating the relationship between the type of pattern element and the correction value can be generated. Note that the correction value for correcting the volume error by the dimension of the pattern element in in the plane direction may be referred to as the "data bias amount" hereinafter. Details of a method of determining the data bias amount will be described later.

In step S15, the information processing apparatus 21 obtains the design data of the mold M to be used in the imprint apparatus 10. If the design data of the mold M is generated in the information processing apparatus 21, the design data is stored in the storage unit 21b. In this case, the information processing apparatus 21 obtains (reads out) the design data from the storage unit 21b. On the other hand, if the design data of the mold M is stored in an external apparatus (an apparatus different from the information processing apparatus 21) connected to the network 23, the information processing apparatus 21 obtains the design data from the external apparatus via the network 23.

In step S16, the information processing apparatus 21 corrects the design data of the mold M based on the data bias amount. More specifically, for each of the plurality of types of pattern elements constituting the pattern of the mold M in the design data, the information processing apparatus 21 obtains (selects) the data bias amount from the correction information in accordance with the type of pattern element. Then, for each of the plurality of types of pattern elements, the information processing apparatus 21 changes the dimension of the pattern element in the plane direction (the direction parallel to the surface of the mold M) in accordance with the obtained data bias amount.

In this manner, the design data of the mold M can be corrected. By performing an imprint process using the mold M fabricated based on the corrected design data, the controllability of the dimension (for example, the controllability of the film thickness) of the concave-convex pattern of the imprint material IM formed on a substrate can be improved. That is, it is possible to accurately form a pattern in the imprint material IM on the substrate S.

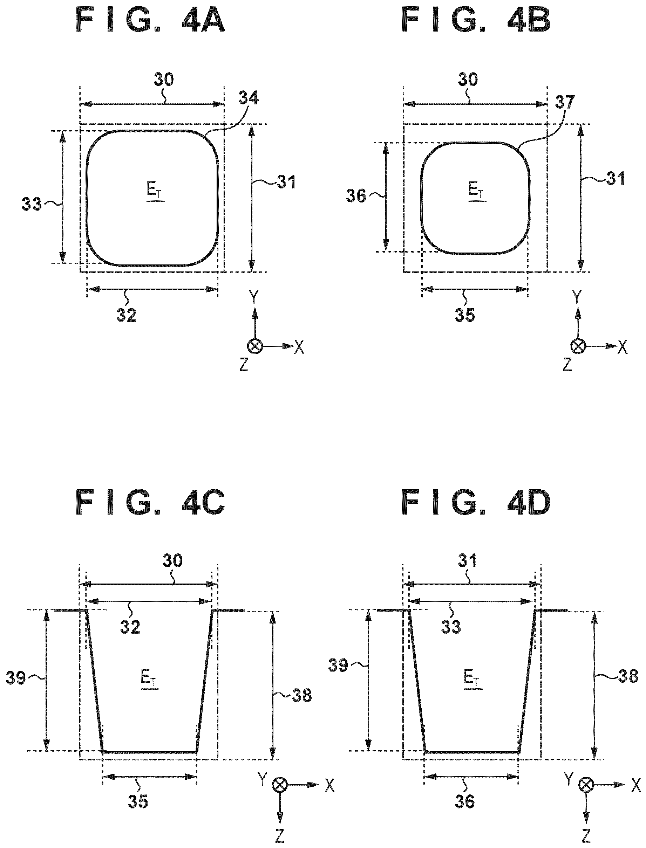

Next, the method of determining the data bias amount (steps S13 and S14) will be described. When determining the data bias amount, the area and dimension of the pattern element measured by the measurement apparatus 22 in step S12 described above are defined as shown in Figs. 4A to 4D. Figs. 4A to 4D show the definitions of the area and dimension of a pattern element $E_T$. In Figs. 4A to 4D, a solid line indicates the actual measurement value of the measurement apparatus 22, and a broken line indicates the design value in the test design data.

Fig. 4A shows a plan view of the opening region formed by the pattern element $E_T$ in the surface of the test mold when viewed from the -Z direction. As described above, the pattern element $E_T$ is formed in a concave shape by being recessed from the surface of the test mold so that it is formed as an opening in the surface of the test mold. However, for the sake of descriptive convenience, this region may be referred to as "the top surface of the pattern element $E_T$" hereinafter. As shown in Fig. 4A, the top surface of the pattern element $E_T$ has a shape with rounded corners due to the fabrication process. A design value 30 of the X-direction width of the pattern element $E_T$ at the top surface is defined as $X_D$ [nm], and a design value 31 of the Y-direction width is defined as $Y_D$ [nm]. An actual measurement value 32 of the X-direction width of the pattern element $E_T$ at the top surface is defined as $X_{AT}$ [nm], and an actual measurement value 33 of the Y-direction width is defined as $Y_{AT}$ [nm]. An actual measurement value 34 of the area of the pattern element $E_T$ at the top surface is defined as $S_{AT}$ [nm$^2$].

Fig. 4B shows a plan view of the bottom surface of the pattern element $E_T$ in the test mold when viewed from the -Z direction. As shown in Fig. 4B, the bottom surface of the pattern element $E_T$ has a shape with rounded corners due to the fabrication process, similar to the top surface of the pattern element $E_T$. The design values of the X-direction width and the Y-direction width of the pattern element $E_T$ at the bottom surface are the same as the design values 30 and 31 of the X-direction width and the Y-direction width of the pattern element $E_T$ at the top surface, respectively. That is, the pattern element $E_T$ in the example shown in Figs. 4A to 4D is designed in a rectangular prism shape. An actual measurement value 35 of the X-direction width of the pattern element $E_T$ at the bottom surface is defined as $X_{AB}$ [nm], and an actual measurement value 36 of the Y-direction width is defined as $Y_{AB}$ [nm]. An actual measurement value 37 of the area of the pattern element $E_T$ at the bottom surface is defined as $S_{AB}$ [nm$^2$].

Fig. 4C shows an X-Z sectional view of the pattern element $E_T$ in the test mold. Fig. 4D shows a Y-Z sectional view of the pattern element $E_T$ in the test mold. As shown in Figs. 4C and 4D, the pattern element $E_T$ can be formed in a tapered shape in the test mold. A design value 38 of the depth of the pattern element $E_T$ is defined as $H_D$ [nm], and an actual measurement value 39 of the depth of the pattern element $E_T$ is defined as $H_A$ [nm].

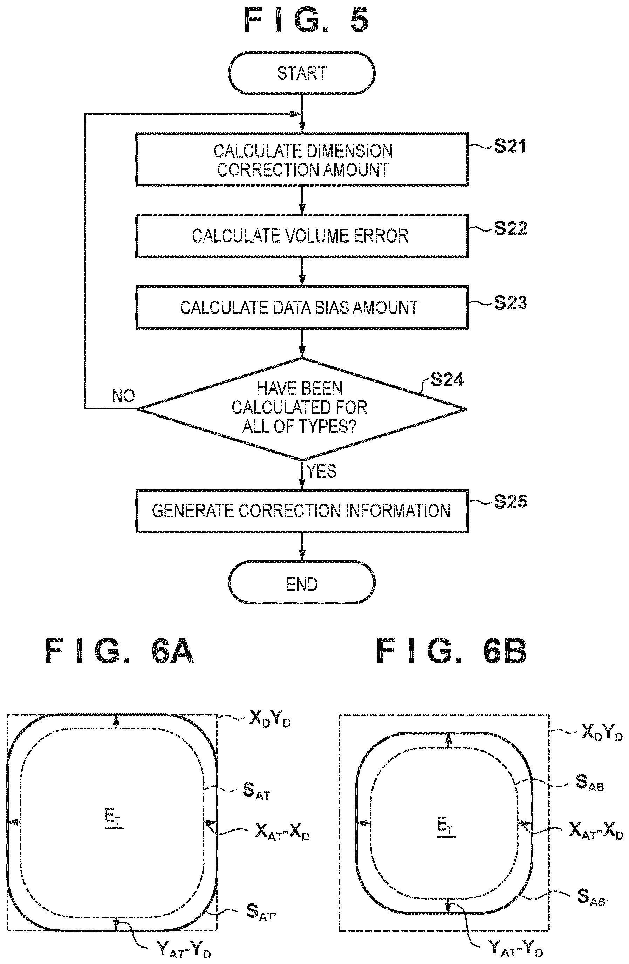

Fig. 5 is a flowchart illustrating the method of determining the data bias amount. The flowchart of Fig. 5 is executed by the information processing apparatus 21 (processor 21a). Here, the pattern element $E_T$ whose dimension and area are defined as described above with reference to Figs. 4A to 4D will be exemplified and described.

In step S21, the information processing apparatus 21 calculates dimension correction amounts $P_{XAT}$ and $P_{YAT}$ for each of the top surface and bottom surface of the pattern element $E_T$. The dimension correction amount $P_{XAT}$ is a correction value for correcting the X-direction dimension (width) without considering the volume error. The dimension correction amount $P_{YAT}$ is a correction value for correcting the Y-direction dimension (width) without considering the volume error. In the fabrication process of the pattern element $E_T$, there may be anisotropy between the X direction and the Y direction. Therefore, the dimension correction amounts can be calculated separately for the X direction and the Y direction.

More specifically, as shown in Fig. 6A, an area $S_{AT}$' of the top surface of the pattern element $E_T$ when the X-direction width and the Y-direction width are increased to the design values without changing the rounding amounts of the corners is calculated by equation (1). The first term "$X_D Y_D$" in equation (1) represents the design area of the top surface of the pattern element $E_T$, and the second term "$X_{AT} Y_{AT} - S_{AT}$" represents the area reduction amount due to the roundings of the corners.

$$S'_{AT} = X_D Y_D - (X_{AT} Y_{AT} - S_{AT}) \qquad \ldots (1)$$

In addition, as shown in Fig. 6B, an area $S_{AB}$' of the bottom surface of the pattern element $E_T$ when the X-direction width and the Y-direction width are increased without changing the rounding amounts of the corners and the taper angle of the pattern element $E_T$ is calculated by equation (2). The concept of equation (2) is similar to that of equation (1), but the first term "$(X_D - X_{AT} + X_{AB})(Y_D - Y_{AT} + Y_{AB})$" in equation (2) represents the value obtained by subtracting the area reduction amount due to the tapered shape of the pattern element $E_T$ from the design area of the bottom surface of the pattern element $E_T$. The second term "$X_{AB} Y_{AB} - S_{AB}$" in equation (2) represents the area reduction amount due to the roundings of the corners.

$$S'_{AB} = (X_D - X_{AT} + X_{AB})(Y_D - Y_{AT} + Y_{AB}) - (X_{AB} Y_{AB} - S_{AB}) \qquad \ldots (2)$$

With this, the dimension correction amounts $P_{XAT}$ and $P_{YAT}$ can be calculated by following equations (3) and (4).

$$P_{XAT} = X_{AT} - X_D \qquad \qquad ...(3)$$

$$P_{YAT} = Y_{AT} - Y_D \qquad \qquad ...(4)$$

In step S22, the information processing apparatus 21 calculates the difference (volume error $V_A$) between the actual volume and design volume of the pattern element $E_T$. The volume error $V_A$ can be calculated by equation (5).

$$V_A = \frac{H_A}{3}\left(S'_{AT} + S'_{AB} + \sqrt{S'_{AT}S'_{AB}}\right) \qquad \qquad ...(5)$$

In step S23, the information processing apparatus 21 calculates a data bias amount Pv for correcting the volume error $V_A$ by the dimension of the pattern element $E_T$ in the plane direction (X and Y directions). In this embodiment, the data bias amount Pv is calculated assuming that the volume error $V_A$ is applied evenly to the X direction and the Y direction. The relationship between the data bias amount Pv and the volume error $V_A$ can be expressed as equation (6). Accordingly, equation (7) is derived from equations (5) and (6), and the data bias amount Pv is calculated by equation (7).

$$(X_D + P_v)(Y_D + P_v) = V_A \qquad \qquad ...(6)$$

$$P_V = \frac{1}{2H_D}\Big\{-(X_D H_D + Y_D H_D) +$$

$$\sqrt{(X_D H_D + Y_D H_D)^2 - 4H_D(X_D Y_D H_D - V_A)}\Big\} \qquad \qquad ...(7)$$

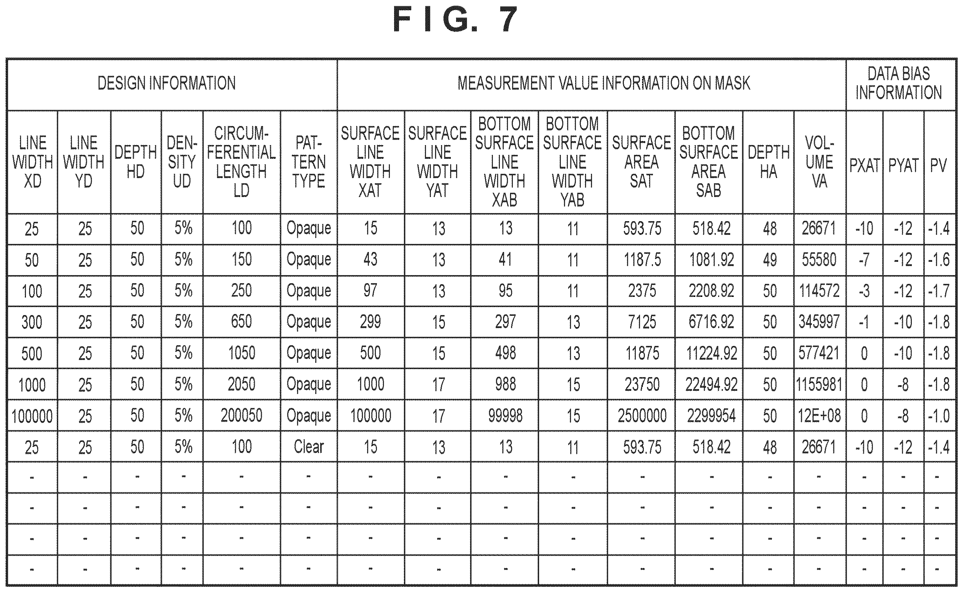

In step S24, the information processing apparatus 21 determines whether the data bias amounts Pv have been calculated for all of the plurality of types of pattern elements formed in the test mold. If there is the type of pattern element for which the data bias amount $P_V$ has not been calculated yet, steps S21 to S23 are performed for this type of pattern element. On the other hand, if the data bias amounts Pv have been calculated for all of the plurality of types of pattern elements, the process advances to step S25, and the information processing apparatus 21 generates correction information (for example, a table) indicating the relationship between the type of pattern element and the data bias amount. Fig. 7 shows an example of the correction information.

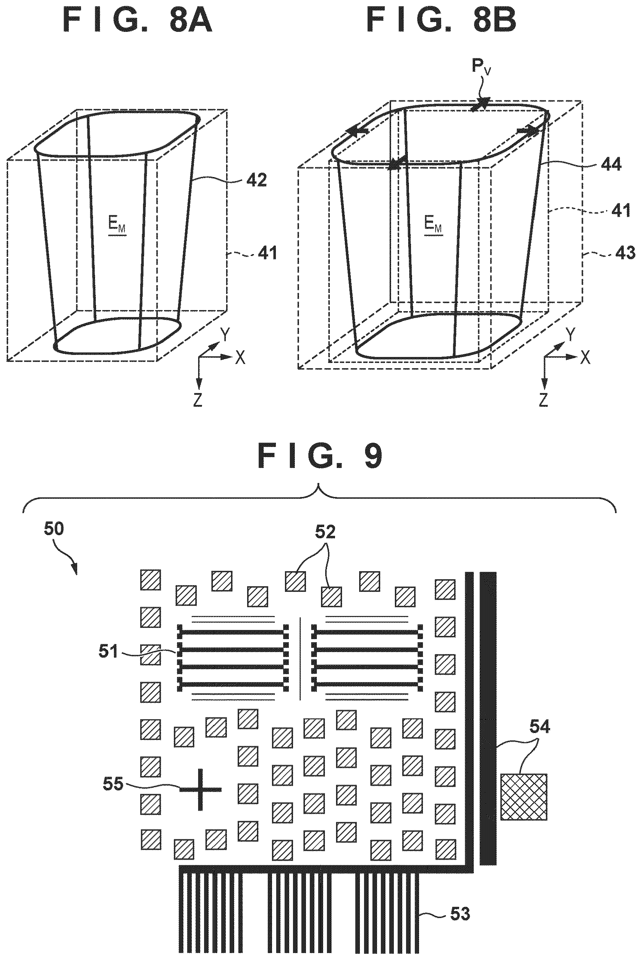

Figs. 8A and 8B show an example of correcting the dimension of one pattern element $E_M$ in the plane direction in accordance with the data bias amount Pv in the design data of the mold M. Fig. 8A shows a pre-correction design shape 41 of the pattern element $E_M$, and a shape 42 (to be sometimes referred to as the pre-correction actual shape 42 hereinafter) actually fabricated using the pre-correction design shape 41. Fig. 8B shows a post-correction design shape 43 of the pattern element $E_M$, which has been corrected using the data bias amount Pv, and a shape 44 (to be sometimes referred to as the post-correction actual shape 44 hereinafter) actually fabricated using the post-correction design shape 43.

The post-correction design shape 43 can be obtained by increasing the dimension of the pre-correction design shape 41 in the plane direction (X and Y directions) by the data bias amount Pv. With this, in the pattern element $E_M$ fabricated in accordance with the post-correction design shape 43, the volume of the post-correction actual shape 44 can be made close to the volume of the pre-correction design shape 41. That is, it is possible to reduce the difference between the volume of the post-correction actual shape 44 and the volume of the pre-correction design shape 41.

As described above, in this embodiment, the data bias amount for correcting, by the dimension in the plane direction, the difference (volume error) between the actual volume and the design volume of the pattern element formed in the test pattern is determined, and the design data of the mold M is corrected based on the data bias amount. According to this method, it is possible to easily correct the design data so as to reduce the volume error. Then, by performing an imprint process using the mold M fabricated based on the corrected design data, it is possible to accurately form a pattern in the imprint material IM on the substrate S.

<Second Embodiment>

The second embodiment according to the present disclosure will be described. This embodiment basically takes over the first embodiment, and matters not mentioned below can follow the first embodiment.

A method of correcting design data in this embodiment can be performed according to the flowchart of Fig.3 described above in the first embodiment, but step S11 (test mold preparation step) is different from that in the first embodiment. In this embodiment, a test mold is fabricated based on the pre-correction design data generated for a mold M to be used in an imprint apparatus 10. Similar to the test mold in the first embodiment, the test mold in this embodiment can include a plurality of types of pattern elements that can constitute the pattern of the mold M.

Fig. 9 shows an example of pre-correction design data 50 generated for the pattern of the mold M to be used in the imprint apparatus 10. The pre-correction design data 50 can include various types of pattern elements such as a main pattern 51, a dummy pattern 52, a peripheral pattern 53, an accessary pattern 54, and a monitor pattern 55.

The main pattern 51 is a pattern for forming the circuit (for example, wiring) of a semiconductor device, and optical proximity effect correction may be performed. The dummy pattern 52 is a pattern arranged around the main pattern 51 to reduce the difference in the pattern density (occupation density) per unit area, thereby improving the film thickness uniformity (flatness) of a cured film formed on a substrate by an imprint process. The dummy pattern 52 is not used as the circuit of the semiconductor device, so that the requirements concerning the dimension and arrangement are less severe than those for the main pattern 51.

The peripheral pattern 53 is a pattern for forming a control circuit used to control the circuit of the semiconductor device formed by the main pattern 51, and can be arranged around the region where the main pattern 51 is provided. The accessary pattern 54 is a pattern forming a scribe line used to cut each semiconductor device formed on the substrate S into a chip and/or a pattern forming an ID code (for example, a bar code) to be read in a manufacturing step or by a peripheral apparatus. The monitor pattern 55 is a pattern for managing the quality of the semiconductor device, and may be a pattern forming an alignment mark. If the main pattern 51 has undergone optical proximity effect correction, it is difficult to measure the main pattern 51, so that the monitor pattern 55 can be provided. The monitor pattern 55 can be formed in a simple shape with the same dimension accuracy as the main pattern 51.

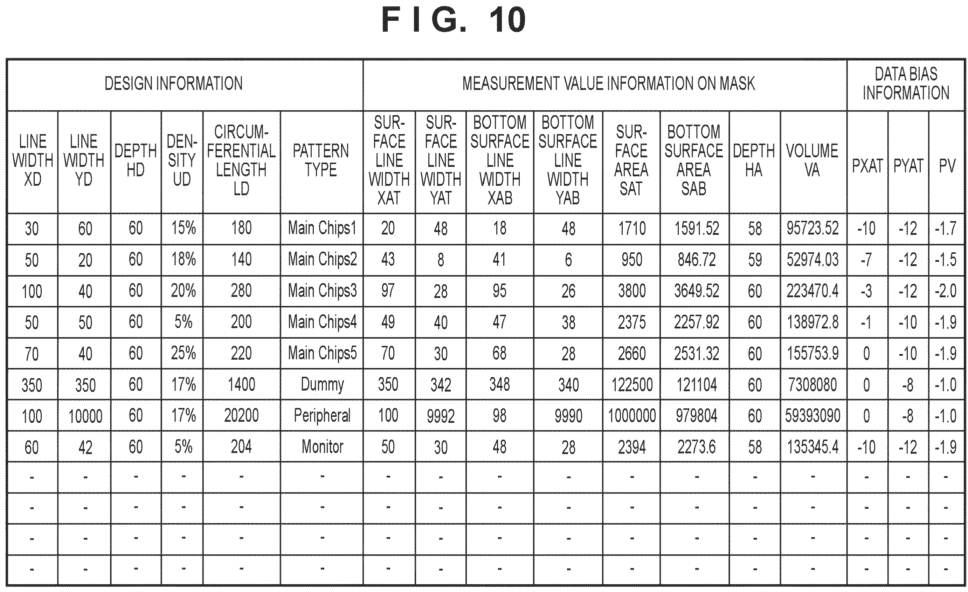

In this embodiment, as in the first embodiment, the data bias amount of each type of pattern element is determined in steps S12 to S14 to generate correction information. Fig. 10 shows an example of the correction information. In steps S15 and S16, the design data 50 of the mold M is corrected using the data bias amount. Here, if the layer components of the pre-correction design data 50 are separated for each type of pattern element, a representative portion of each type of pattern element may be sampled, and the area and dimension of each type of pattern element may be measured by a measurement apparatus 22 in step S12. Note that a method of determining the data bias amount in this embodiment is similar to that in the first embodiment, and a description here is omitted.

As described above, in this embodiment, a test mold is fabricated based on the pre-correction design data generated for the pattern of the mold M to be used in the imprint apparatus 10. According to this embodiment as well, as in the first embodiment, it is possible to easily correct the design data so as to reduce the volume error. By performing an imprint process using the mold M fabricated based on the post-correction design data, it is possible to accurately form a pattern in an imprint material IM on a substrate S.

<Third Embodiment>

The third embodiment according to the present disclosure will be described. This embodiment basically takes over the first embodiment, and matters not mentioned below can follow the first embodiment. The second embodiment may be applied in this embodiment.

In this embodiment, an example will be described in which the pattern (pre-correction design data) of a mold M includes the first pattern element for forming a device on a substrate S, and the second pattern element arranged around the first pattern element to adjust the pattern density on the mold. The first pattern element can include the main pattern 51 described above in the second embodiment, and the second pattern element can include the dummy pattern 52 described above in the second embodiment.

A case is assumed in which the dimension such as a line width is strictly defined for the first pattern element (main pattern 51) so the dimension of the first pattern element is uncorrectable. Therefore, in this embodiment, dimension correction using the data bias amount is not performed for the first pattern element, and dimension correction using the data bias amount is performed only for the second pattern element. Furthermore, in this embodiment, the data bias amount to be applied to the second pattern element can be determined based on not only the volume error of the second pattern element but also the volume error of the first pattern element.

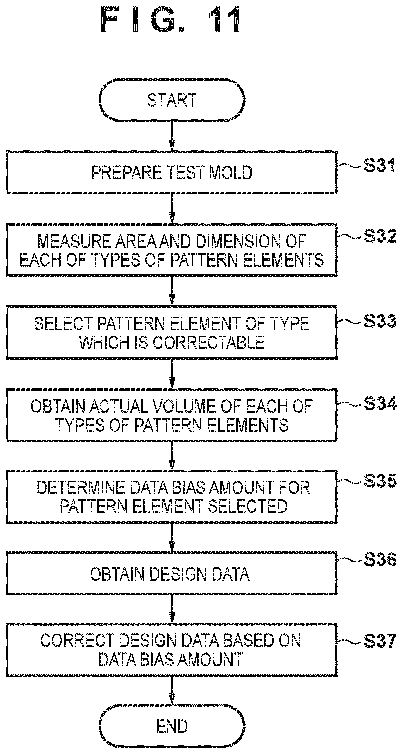

Fig. 11 is a flowchart illustrating a method of correcting design data in this embodiment. In the flowchart of Fig. 11, step S32 can be performed by a measurement apparatus 22, and steps S33 to S37 can be performed by an information processing apparatus 21 (processor 21a).

In step S31, a test mold is prepared. For fabrication of the test mold, the first embodiment may be applied, or the second embodiment may be applied. Then, in step S32, the measurement apparatus 22 is used to measure the area and dimension of each of a plurality of types of pattern elements formed in the test mold. Note that steps S31 and S32 are similar to steps S11 and S12 of the flowchart of Fig. 3, and a detailed description here is omitted.

In step S33, from the plurality of types of pattern elements, the information processing apparatus 21 selects (specifies) a pattern element of the type whose dimension in the plane direction is correctable using the data bias amount. In this embodiment, as a pattern element of the correctable type, the second pattern element (dummy pattern 52) is selected, and the first pattern element (main pattern 51) is not selected. Selection of the pattern element of the correctable type can be performed based on information indicating whether each type of pattern element is correctable. This information can be defined by design data or data obtained together with the design data.

In step S34, the information processing apparatus 21 obtains (calculates) the actual volume of each of the plurality of types of pattern elements. In step S35, the information processing apparatus 21 determines the data bias amount for the pattern element of the type selected in step S33. In this embodiment, when determining the data bias amount for the type of pattern element selected in step S33, the volume error of the type of pattern element not selected in step S33 is also taken into consideration. For example, the data bias amount (to be sometimes referred to as the data bias amount of the second pattern element hereinafter) applied to the second pattern element is determined based on the volume error of the first pattern element and the volume error of the second pattern element.

The information processing apparatus 21 can determine the data bias amount of the second pattern element so as to reduce the difference (to be sometimes referred to as the density difference hereinafter) between the volume density of the first pattern element and the volume density of the second pattern element. The volume density can be defined as the occupation density of the volume of the pattern element per unit volume.

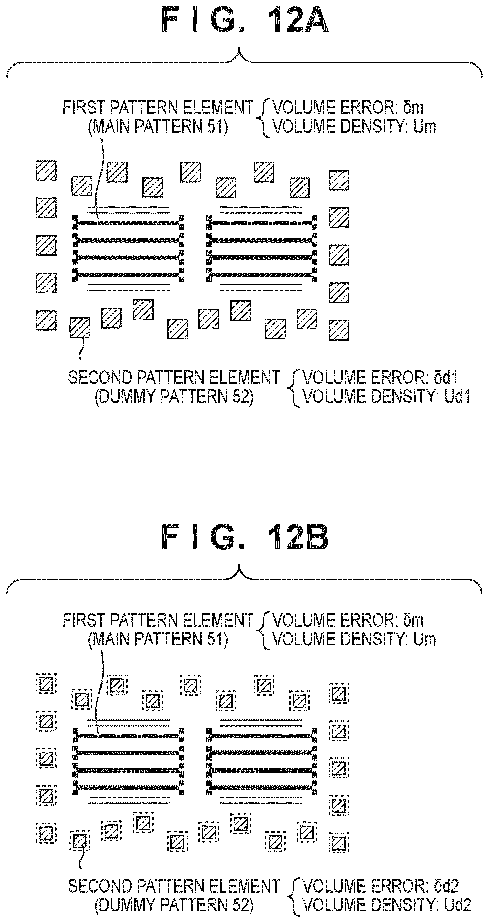

For example, as shown in Figs. 12A and 12B, in accordance with the reduction in volume density of the first pattern element, the volume density of the second pattern element is reduced so as to reduce the density difference. Fig. 12A shows the configurations and arrangements of the first pattern element (main pattern 51) and the second pattern element (dummy pattern 52) in pre-correction design data. Fig. 12B shows the configurations and arrangements of the first pattern element and the second pattern element in post-correction design data. In this case, the information processing apparatus 21 determines the data bias amount of the second pattern element such that the volume of the second pattern element is reduced by the amount corresponding to the volume error of the first pattern element. For example, the information processing apparatus 21 determines the data bias amount of the second pattern element so as to make a volume density $Ud2$ of the second pattern element equal to a volume density $Um$ of the first pattern element. By correcting the dimension of each second pattern element in the design data based on the data bias amount determined in this manner, the density difference can be reduced.

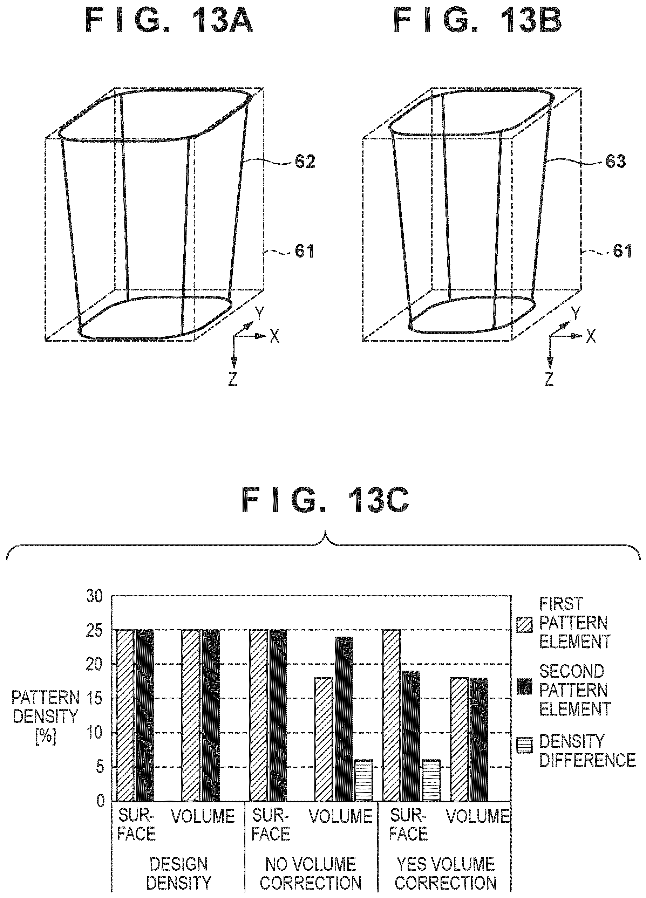

Figs. 13A to 13C show an example of the result of correcting the design data of the mold M in this embodiment. Fig. 13A shows a design shape 61 of the second pattern element (dummy pattern 52) in pre-correction design data, and an actual shape 62 of the second pattern element fabricated using post-correction design data. Fig. 13B shows an actual shape 63 of the second pattern element reduced by the amount corresponding to the volume error of the first pattern element. Fig. 13C shows the results of the pattern density on the surface and the volume density of each of the first pattern element and the second pattern element. As shown in Fig. 13C, with the post-correction design data, there is a divergence in the pattern density on the surface between the first pattern element and the second pattern element, but the difference in the volume density is reduced between the first pattern element and the second pattern element.

Here, the information processing apparatus 21 may determine the data bias amount of the second pattern element based on the sum value of the volume error of the first pattern element and the volume error of the second pattern element. In this case, the data bias amount of the second pattern element can be determined basically according to the flowchart of Fig. 5. The information processing apparatus 21 calculates the volume error of the first pattern element and the volume error of the second pattern element by performing steps S21 and S22 for each of the first pattern element and the second pattern element. Each of the volume error of the first pattern element and the volume error of the second pattern element can be calculated using equations (1) to (5). Then, in step S23, the information processing apparatus 21 calculates the data bias amount of the second pattern element. More specifically, the sum value of the volume error of the first pattern element and the volume error of the second pattern element calculated in steps S21 and S22 is substituted for a volume error $V_A$ in equation (7). A data bias amount Pv obtained from equation (7) can be calculated as a data bias amount $P_{MV}$ of the second pattern element.

If a plurality of first pattern elements and a plurality of second pattern elements are provided, the sum value of the volume error for all of the plurality of first pattern elements and the volume error for all of the plurality of second pattern elements may be distributed to the plurality of second pattern elements. Based on a value obtained by dividing the sum value by the number of the second pattern elements, the data bias amount $P_{MV}$ of each second pattern element may be calculated.

Referring back to Fig. 11, in step S36, the information processing apparatus 21 obtains the design data of the mold M to be used in the imprint apparatus 10. Then, in step S37, the information processing apparatus 21 corrects the design data of the mold M based on the data bias amount $P_{MV}$ for the pattern element (second pattern element) of the type selected in step S33. Note that steps S36 and S37 are similar to steps S15 and S16 of the flowchart of Fig. 3, and a detailed description is omitted here.

As described above, in this embodiment, based on the volume error of the first pattern element and the volume error of the second pattern element, the dimension of the second pattern element in the design data is corrected. According to this embodiment, even if there is the pattern element of the uncorrectable type (first pattern element), the volume error in the entire mold can be reduced using the pattern element of the correctable type (second pattern element). According to this embodiment, it is possible to easily correct the design data so as to reduce the volume error, as in the first and second embodiments. By performing an imprint process using the mold M fabricated based on the post-correction design data, it is possible to accurately form a pattern in an imprint material IM on the substrate S.

<Embodiment of Article Manufacturing Method>

An article manufacturing method according to the embodiment of the present disclosure is suitable for manufacturing an article, for example, a microdevice such as a semiconductor device or a device having a microstructure. The article manufacturing method according to this embodiment includes a forming step of forming a pattern to an imprint material on a substrate using the above-described imprint method (imprint apparatus), a processing step of processing the substrate having the imprint material to which the pattern has been formed, and a manufacturing step of manufacturing an article from the processed substrate. The article manufacturing method further includes other known steps (oxidation, film formation, deposition, doping, planarization, etching, resist removal, dicing, bonding, packaging, and the like). The article manufacturing method of this embodiment is more advantageous than the conventional methods in at least one of the performance, quality, productivity, and production cost of the article.

The pattern of a cured product formed using the above-described imprint apparatus is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, an SRAM, a flash memory, and an MRAM and semiconductor elements such as an LSI, a CCD, an image sensor, and an FPGA. Examples of the mold are a mold for imprint and the like.

The pattern of the cured product is directly used as the constituent member of at least some of the above-described articles or used temporarily as a resist mask. After etching or ion implantation is performed in the processing step of the substrate, the resist mask is removed.

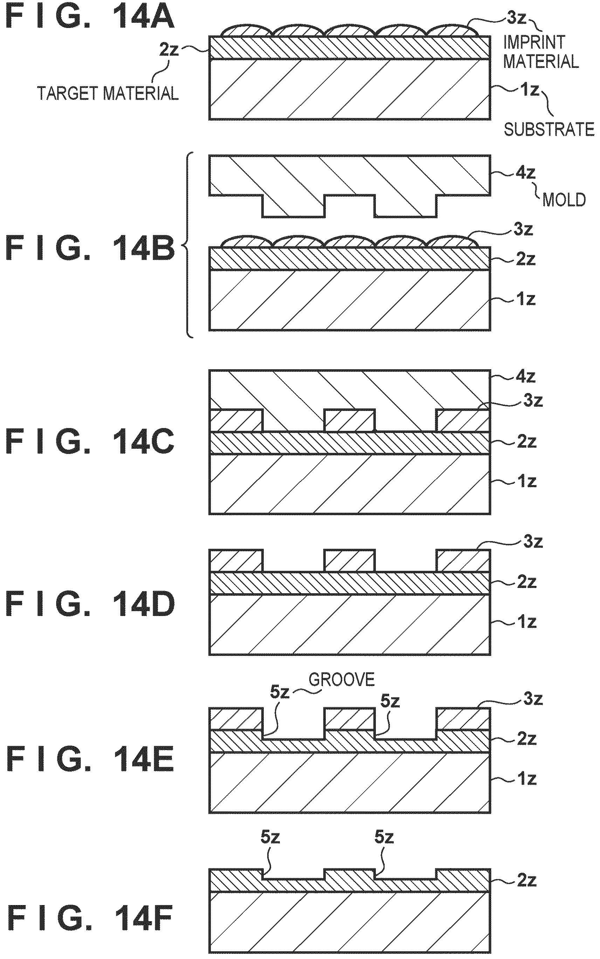

Next, a specific method of manufacturing an article will be described. As shown in Fig. 14A, a substrate 1z such as a silicon wafer with a target material 2z to be processed, such as an insulator, formed on the surface is prepared. Next, an imprint material 3z is applied to the surface of the target material 2z by an inkjet method or the like. A state in which the imprint material 3z is applied as a plurality of droplets onto the substrate is shown here.

As shown in Fig. 14B, a side of a mold 4z for imprint, where a concave-convex pattern is formed, is directed to face the imprint material 3z on the substrate. As shown in Fig. 14C, the mold 4z and the substrate 1z to which the imprint material 3z is applied are brought into contact with each other, and a pressure is applied. The gap between the mold 4z and the target material 2z is filled with the imprint material 3z. In this state, by irradiating the imprint material 3z with energy for curing through the mold 4z, the imprint material 3z is cured.

As shown in Fig. 14D, after the imprint material 3z is cured, the mold 4z is separated from the substrate 1z. Then, the pattern of the cured product of the imprint material 3z is formed on the substrate 1z. In the pattern of the cured product, the concave portion of the mold corresponds to the convex portion of the cured product, and the convex portion of the mold corresponds to the concave portion of the cured product. That is, the pattern with concave and convex portions in the mold 4z is transferred to the imprint material 3z.

As shown in Fig. 14E, by performing etching using the pattern of the cured product as an etching resistant mask, a portion of the surface of the target material 2z where the cured product does not exist or remains thin is removed to form a groove 5z. As shown in Fig. 14F, by removing the pattern of the cured product, an article with the grooves 5z formed in the surface of the target material 2z can be obtained. Here, the pattern of the cured product is removed. However, instead of removing the pattern of the cured product after processing, it may be used as, for example, an interlayer dielectric film included in a semiconductor element or the like, that is, a constituent member of an article.

<Other Embodiments>

Embodiments of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiment(s) and/or that includes one or more circuits (e.g., application specific integrated circuit, ASIC) for performing the functions of one or more of the above-described embodiment(s), and by a method performed by the computer of the system or apparatus by, for example, reading out and executing the computer executable instructions from the storage medium to perform the functions of one or more of the above-described embodiment(s) and/or controlling the one or more circuits to perform the functions of one or more of the above-described embodiment(s). The computer may comprise one or more processors (e.g., central processing unit, CPU, micro processing unit, MPU) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory, ROM, a storage of distributed computing systems, an optical disk (such as a compact disc, CD, digital versatile disc, DVD, or Blu-ray Disc™, BD), a flash memory device, a memory card, and the like.

Various embodiments have been described in detail above but it will be understood that the present disclosure is not limited to these embodiments and encompasses all modifications, variants, alternatives and equivalents falling within the scope of the appended claims.

**Claims**

1.  A correction method of correcting, by an information processing apparatus (21), design data of a pattern of a mold (M) to be used in an imprint process of forming a pattern in an imprint material (IM) on a substrate (S), **characterized by** comprising:

    obtaining an actual volume of a concave pattern element formed in a test mold;
    determining a correction value for correcting a difference between the actual volume and a design volume of the pattern element by a dimension of the pattern element in a plane direction parallel to a surface of the test mold; and
    correcting the design data based on the correction value.

2.  The method according to claim 1, **characterized in that**
    the correction value is a value defining one of an amount and a ratio of changing a dimension of the pattern element in the plane direction so as to reduce the difference.

3.  The method according to claim 1 or 2, **characterized in that**

    the test mold includes a plurality of types of pattern elements constituting the pattern of the mold,
    for each of the plurality of types of pattern elements, an actual volume is obtained in the obtaining, and the correction value is determined in the determining, and
    in the correcting, the design data is corrected based on the correction value determined for each of the plurality of types of pattern elements.

4.  The method according to claim 3, **characterized in that**
    the plurality of types of pattern elements are different from each other in at least one of a dimension, a depth, and an occupation density per unit area.

5.  The method according to claim 3 or 4, **characterized in that**
    the test mold is fabricated based on the design data before correction.

6.  The method according to any one of claims 3 to 5, **characterized in that**
    in the determining, information indicating a relationship between the type of pattern element and the correction value is generated.

7.  The method according to any one of claims 1 to 6, **characterized in that**
    in the obtaining, the actual volume of the pattern element is obtained based on a result of measuring an area and a dimension of an opening region formed by the pattern element in the surface, an area and a dimension of a bottom surface of the pattern element, and a depth of the pattern element.

8.  The method according to any one of claims 1 to 7, **characterized in that**
    the pattern element has a tapered shape in a depth direction.

9.  The method according to any one of claims 1 to 8, **characterized in that**

    the pattern of the mold includes a first pattern element for forming a device on the substrate, and a second pattern element arranged around the first pattern element to adjust a pattern density on the mold,
    in the determining, the correction value for the second pattern element is determined based on a difference between an actual volume and a design volume of the first pattern element and a difference between an actual volume and a design volume of the second pattern element, and
in the correcting, a dimension of the second pattern element in the design data is corrected based on the correction value.

10. The method according to claim 9, **characterized in that**
in the correcting, a dimension of the first pattern element in the design data is not corrected.

11. A mold manufacturing method **characterized by** comprising:

correcting, by using a correction method defined in any one of claims 1 to 10, design data of a pattern of a mold (M) to be used in an imprint process of forming a pattern in an imprint material (IM) on a substrate (S); and
fabricating the mold based on the corrected design data.

12. An imprint method of forming a pattern in an imprint material (IM) on a substrate (S) using a mold (M), **characterized in that**
the mold is manufactured using a mold manufacturing method defined in claim 11.

13. An article manufacturing method **characterized by** comprising:

forming a pattern in an imprint material (IM) on a substrate (S) using an imprint method defined in claim 12;
processing the substrate including the imprint material formed with the pattern; and
manufacturing an article from the processed substrate.

14. An information processing apparatus (21) that corrects design data of a pattern of a mold (M) to be used in an imprint process of forming a pattern in an imprint material (IM) on a substrate (S), **characterized in that** the apparatus is configured to:

obtain an actual volume of a concave pattern element formed in a test mold;
determine a correction value for correcting a difference between the actual volume and a design volume of the pattern element by a dimension of the pattern element in a plane direction parallel to a surface of the test mold; and
correct the design data based on the correction value.

# F I G. 1

# F I G. 2

# F I G. 3

```
                    ┌─────────────┐
                    │    START    │
                    └──────┬──────┘
                           │
                           ▼
      ┌──────────────────────────────────────┐
      │          PREPARE TEST MOLD           │─── S11
      └──────────────────┬───────────────────┘
                           │
                           ▼
      ┌──────────────────────────────────────┐
      │     MEASURE AREA AND DIMENSION OF     │─── S12
      │   EACH OF TYPES OF PATTERN ELEMENTS   │
      └──────────────────┬───────────────────┘
                           │
                           ▼
      ┌──────────────────────────────────────┐
      │    OBTAIN ACTUAL VOLUME OF EACH OF    │─── S13
      │       TYPES OF PATTERN ELEMENTS       │
      └──────────────────┬───────────────────┘
                           │
                           ▼
      ┌──────────────────────────────────────┐
      │    DETERMINE DATA BIAS AMOUNT OF      │─── S14
      │   EACH OF TYPES OF PATTERN ELEMENTS   │
      └──────────────────┬───────────────────┘
                           │
                           ▼
      ┌──────────────────────────────────────┐
      │           OBTAIN DESIGN DATA          │─── S15
      └──────────────────┬───────────────────┘
                           │
                           ▼
      ┌──────────────────────────────────────┐
      │    CORRECT DESIGN DATA BASED ON       │─── S16
      │          DATA BIAS AMOUNT             │
      └──────────────────┬───────────────────┘
                           │
                           ▼
                    ┌─────────────┐
                    │     END     │
                    └─────────────┘
```

# FIG. 4A

30
34
33
$E_T$
31
32

Y
⊗→X
Z

# FIG. 4B

30
37
36
$E_T$
31
35

Y
⊗→X
Z

# FIG. 4C

30
32
39
$E_T$
38
35

Y ⊗ → X
Z

# FIG. 4D

31
33
39
$E_T$
38
36

Y ⊗ → X
Z

# F I G. 5

```
        ( START )
            │
            ▼
┌─────────────────────────────┐
│   CALCULATE DIMENSION       │────  S21
│   CORRECTION AMOUNT         │
└─────────────────────────────┘
            │
            ▼
┌─────────────────────────────┐
│   CALCULATE VOLUME ERROR    │────  S22
└─────────────────────────────┘
            │
            ▼
┌─────────────────────────────┐
│  CALCULATE DATA BIAS AMOUNT │────  S23
└─────────────────────────────┘
            │
            ▼
         ╱────────╲
    NO ╱ HAVE BEEN  ╲   S24
◄─────┤ CALCULATED FOR├
       ╲ ALL OF TYPES?╱
         ╲────────╱
            │ YES
            ▼
┌─────────────────────────────┐
│ GENERATE CORRECTION INFORMATION │────  S25
└─────────────────────────────┘
            │
            ▼
         ( END )
```

# F I G. 6A          F I G. 6B

# F I G. 7

| DESIGN INFORMATION | | | | | | MEASUREMENT VALUE INFORMATION ON MASK | | | | | | | | DATA BIAS INFORMATION | | |
|---|---|---|---|---|---|---|---|---|---|---|---|---|---|---|---|---|
| LINE WIDTH XD | LINE WIDTH YD | DEPTH HD | DEN-SITY UD | CIRCUM-FERENTIAL LENGTH LD | PAT-TERN TYPE | SURFACE LINE WIDTH XAT | SURFACE LINE WIDTH YAT | BOTTOM SURFACE LINE WIDTH XAB | BOTTOM SURFACE LINE WIDTH YAB | SURFACE AREA SAT | BOTTOM SURFACE AREA SAB | DEPTH HA | VOL-UME VA | PXAT | PYAT | PV |
| 25 | 25 | 50 | 5% | 100 | Opaque | 15 | 13 | 13 | 11 | 593.75 | 518.42 | 48 | 26671 | -10 | -12 | -1.4 |
| 50 | 25 | 50 | 5% | 150 | Opaque | 43 | 13 | 41 | 11 | 1187.5 | 1081.92 | 49 | 55580 | -7 | -12 | -1.6 |
| 100 | 25 | 50 | 5% | 250 | Opaque | 97 | 13 | 95 | 11 | 2375 | 2208.92 | 50 | 114572 | -3 | -12 | -1.7 |
| 300 | 25 | 50 | 5% | 650 | Opaque | 299 | 15 | 297 | 13 | 7125 | 6716.92 | 50 | 345997 | -1 | -10 | -1.8 |
| 500 | 25 | 50 | 5% | 1050 | Opaque | 500 | 15 | 498 | 13 | 11875 | 11224.92 | 50 | 577421 | 0 | -10 | -1.8 |
| 1000 | 25 | 50 | 5% | 2050 | Opaque | 1000 | 17 | 988 | 15 | 23750 | 22494.92 | 50 | 1155981 | 0 | -8 | -1.8 |
| 100000 | 25 | 50 | 5% | 200050 | Opaque | 100000 | 17 | 99998 | 15 | 2500000 | 2299954 | 50 | 12E+08 | 0 | -8 | -1.0 |
| 25 | 25 | 50 | 5% | 100 | Clear | 15 | 13 | 13 | 11 | 593.75 | 518.42 | 48 | 26671 | -10 | -12 | -1.4 |
| - | - | - | - | - | - | - | - | - | - | - | - | - | - | - | - | - |
| - | - | - | - | - | - | - | - | - | - | - | - | - | - | - | - | - |
| - | - | - | - | - | - | - | - | - | - | - | - | - | - | - | - | - |
| - | - | - | - | - | - | - | - | - | - | - | - | - | - | - | - | - |

EP 4 707 922 A2

# F I G. 8A

# F I G. 8B

# F I G. 10

| DESIGN INFORMATION | | | | | | MEASUREMENT VALUE INFORMATION ON MASK | | | | | | | | DATA BIAS INFORMATION | | |
|---|---|---|---|---|---|---|---|---|---|---|---|---|---|---|---|---|
| LINE WIDTH XD | LINE WIDTH YD | DEPTH HD | DEN-SITY UD | CIRCUM-FERENTIAL LENGTH LD | PATTERN TYPE | SUR-FACE LINE WIDTH XAT | SUR-FACE LINE WIDTH YAT | BOTTOM SURFACE LINE WIDTH XAB | BOTTOM SURFACE LINE WIDTH YAB | SUR-FACE AREA SAT | BOTTOM SURFACE AREA SAB | DEPTH HA | VOLUME VA | PXAT | PYAT | PV |
| 30 | 60 | 60 | 15% | 180 | Main Chips1 | 20 | 48 | 18 | 48 | 1710 | 1591.52 | 58 | 95723.52 | -10 | -12 | -1.7 |
| 50 | 20 | 60 | 18% | 140 | Main Chips2 | 43 | 8 | 41 | 6 | 950 | 846.72 | 59 | 52974.03 | -7 | -12 | -1.5 |
| 100 | 40 | 60 | 20% | 280 | Main Chips3 | 97 | 28 | 95 | 26 | 3800 | 3649.52 | 60 | 223470.4 | -3 | -12 | -2.0 |
| 50 | 50 | 60 | 5% | 200 | Main Chips4 | 49 | 40 | 47 | 38 | 2375 | 2257.92 | 60 | 138972.8 | -1 | -10 | -1.9 |
| 70 | 40 | 60 | 25% | 220 | Main Chips5 | 70 | 30 | 68 | 28 | 2660 | 2531.32 | 60 | 155753.9 | 0 | -10 | -1.9 |
| 350 | 350 | 60 | 17% | 1400 | Dummy | 350 | 342 | 348 | 340 | 122500 | 121104 | 60 | 7308080 | 0 | -8 | -1.0 |
| 100 | 10000 | 60 | 17% | 20200 | Peripheral | 100 | 9992 | 98 | 9990 | 1000000 | 979804 | 60 | 59393090 | 0 | -8 | -1.0 |
| 60 | 42 | 60 | 5% | 204 | Monitor | 50 | 30 | 48 | 28 | 2394 | 2273.6 | 58 | 135345.4 | -10 | -12 | -1.9 |
| - | - | - | - | - | - | - | - | - | - | - | - | - | - | - | - | - |
| - | - | - | - | - | - | - | - | - | - | - | - | - | - | - | - | - |
| - | - | - | - | - | - | - | - | - | - | - | - | - | - | - | - | - |
| - | - | - | - | - | - | - | - | - | - | - | - | - | - | - | - | - |

EP 4 707 922 A2

# F I G. 11

```
        START
          │
          ▼
┌──────────────────────────────┐
│      PREPARE TEST MOLD       │──S31
└──────────────────────────────┘
          │
          ▼
┌──────────────────────────────┐
│  MEASURE AREA AND DIMENSION  │──S32
│ OF EACH OF TYPES OF PATTERN  │
│           ELEMENTS           │
└──────────────────────────────┘
          │
          ▼
┌──────────────────────────────┐
│  SELECT PATTERN ELEMENT OF   │──S33
│   TYPE WHICH IS CORRECTABLE  │
└──────────────────────────────┘
          │
          ▼
┌──────────────────────────────┐
│  OBTAIN ACTUAL VOLUME OF     │──S34
│   EACH OF TYPES OF PATTERN   │
│           ELEMENTS           │
└──────────────────────────────┘
          │
          ▼
┌──────────────────────────────┐
│  DETERMINE DATA BIAS AMOUNT  │──S35
│  FOR PATTERN ELEMENT SELECTED│
└──────────────────────────────┘
          │
          ▼
┌──────────────────────────────┐
│      OBTAIN DESIGN DATA      │──S36
└──────────────────────────────┘
          │
          ▼
┌──────────────────────────────┐
│  CORRECT DESIGN DATA BASED   │──S37
│     ON DATA BIAS AMOUNT      │
└──────────────────────────────┘
          │
          ▼
         END
```

# F I G. 12A

FIRST PATTERN ELEMENT $\{$ VOLUME ERROR: $\delta m$
(MAIN PATTERN 51) $\{$ VOLUME DENSITY: $Um$

SECOND PATTERN ELEMENT $\{$ VOLUME ERROR: $\delta d1$
(DUMMY PATTERN 52) $\{$ VOLUME DENSITY: $Ud1$

# F I G. 12B

FIRST PATTERN ELEMENT $\{$ VOLUME ERROR: $\delta m$
(MAIN PATTERN 51) $\{$ VOLUME DENSITY: $Um$

SECOND PATTERN ELEMENT $\{$ VOLUME ERROR: $\delta d2$
(DUMMY PATTERN 52) $\{$ VOLUME DENSITY: $Ud2$

# F I G. 13A

# F I G. 13B

# F I G. 13C

FIG. 14A

3z
IMPRINT
MATERIAL
2z
TARGET MATERIAL
1z
SUBSTRATE

FIG. 14B

4z
MOLD
3z
2z
1z

FIG. 14C

4z
3z
2z
1z

FIG. 14D

3z
2z
1z

FIG. 14E

GROOVE
5z
5z
3z
2z
1z

FIG. 14F

5z
5z
2z

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022182991 A